# EUROPEAN PATENT APPLICATION

(11) **EP 4 616 739 A1**
(43) Date of publication of application: **17.09.2025**
(21) Application number: 22965222.7
(22) Date of filing: 11.11.2022
(51) Int. Cl.: A24F 40/51, G01R 27/26, G01V 3/08

(54) **NON-COMBUSTION-TYPE FLAVOR INHALER AND CAPACITIVE SENSOR**

(71) Applicant: Japan Tobacco Inc., Tokyo 105-6927 (JP)
(72) Inventor: INOUE, Jumpei, Tokyo 130-8603 (JP); SAKAI, Ryuji, Tokyo 130-8603 (JP)
(74) Representative: Hoffmann Eitle
(86) International application number: PCT/JP2022/042122
(87) International publication number: WO 2024/100899

(57) **Abstract**

A non-combustion-type flavor inhaler according to the present disclosure is provided with: a housing section in which a flavor stick having a flavor rod part and a suction part is housed in an insertable and extractable manner; a capacitive sensor which is provided with a plurality of electrodes arranged along the housing section and detects an electrostatic capacitance between the plurality of electrodes which varies depending on the state of the flavor stick that is inserted into and extracted from the housing section; and a shield member which covers at least a portion of the plurality of electrodes to electrically shield the portion of the electrodes. With the present disclosure, it is possible to provide a technology for reducing the effect of noise and improving measurement accuracy when an electrostatic capacitance is measured.

## Description

### [TECHNICAL FIELD]

The present invention relates to a non-combustion-type flavor inhaler and a capacitive sensor.

### [BACKGROUND ART]

A non-combustion-type flavor inhalation system has been proposed as an alternative to conventional combustion-type tobacco which is smoked by burning tobacco leaves. For example, heat-not-burn-type tobacco products comprising an electrically heated device having a heater assembly, a battery unit serving as a power source for the heater assembly, and a control unit for controlling a heating element of the heater assembly, etc., and a tobacco stick used together with the electrically heated device are known.

A mechanism for detecting insertion of a tobacco stick by a change in electrostatic capacitance in an inhaler where a user inserts the tobacco stick into a non-combustion-type flavor inhaler and heats the tobacco stick is also known (PTL 1). Furthermore, a mechanism in which a marker is provided to the stick side, and electrostatic capacitance associated with the marker is measured to thereby detect insertion of the tobacco stick or the type of the tobacco stick is known (PTL 2).

### [CITATION LIST]

### [PATENT LITERATURE]

[PTL 1] JP 2017-510270 A
[PTL 2] WO 2019/185748 A1

### [SUMMARY OF INVENTION]

### [TECHNICAL PROBLEM]

In a non-combustion-type flavor inhaler, when detecting the state of the flavor stick (hereinafter also referred to as the tobacco stick) with a capacitive sensor, microscopic electrostatic capacitance of the pF order is detected from conditions such as the size of the electrodes, the distance between electrodes, the material of the flavor stick, etc., and there have been problems such as being susceptible to the effect of noise.

It is an objective of the present disclosure, which takes account of the above-described circumstances, to provide a technology for reducing the effect of noise and improving measurement accuracy when an electrostatic capacitance is measured.

### [SOLUTION TO PROBLEM]

### (Aspect 1)

To achieve the above objective, the non-combustion-type flavor inhaler according to one aspect of the present disclosure comprises:
a housing section in which a flavor stick having a flavor rod part and a suction part is housed in an insertable and extractable manner,
a capacitive sensor which is provided with a plurality of electrodes arranged along the housing section and detects an electrostatic capacitance between the plurality of electrodes which varies depending on the state of the flavor stick that is inserted into and extracted from the housing section; and
a shield member which covers at least a portion of the plurality of electrodes to electrically shield the portion of the electrodes.

### (Aspect 2)

In the above aspect 1, the capacitive sensor may comprise a measurement unit for supplying a signal to the plurality of electrodes and for measuring an electrostatic capacitance between the plurality of electrodes on the basis of the signal via the electrodes, and an amplification unit for amplifying the signal.

### (Aspect 3)

In the above aspect 2, the plurality of electrodes may be made up of a first electrode and a second electrode, and the amplification unit may amplify the signal supplied to the second electrode to increase a potential difference across the first electrode and the second electrode when the signal is supplied.

### (Aspect 4)

In any one of the above aspects 1 to 3, the shield member may be a conductor.

### (Aspect 5)

In any one of the above aspects 1 to 4, the thickness of the shield member may be 1 µm to 1000 µm.

### (Aspect 6)

In any one of the above aspects 1 to 5, the electrodes may be formed on one surface of a flexible substrate and the shield member may be formed on a surface of the flexible substrate opposite to the surface on which the electrodes are formed.

### (Aspect 7)

To achieve the above objective, a capacitive sensor according to one aspect of the present disclosure comprises:
a capacitive sensor provided to a non-combustion-type flavor inhaler comprising a housing section that houses a flavor stick in an insertable and extractable manner, the capacitive sensor comprising:
a plurality of electrodes arranged along the housing section;
a measurement unit for measuring an electrostatic capacitance between the plurality of electrodes which varies depending on the state of the flavor stick that is inserted into and extracted from the housing section; and
a shield member which covers at least a portion of the plurality of electrodes other than a surface opposing the housing section to electrically shield the portion of the electrodes.

### (Aspect 8)

In the above aspect 7, the capacitive sensor may further comprise an amplification unit for amplifying a signal supplied from the measurement unit to the plurality of electrodes.

It should be noted that the means for solving the problem in the present invention can be employed in combination to the greatest extent possible.

### [ADVANTAGEOUS EFFECTS OF INVENTION]

According to the present disclosure, it becomes possible to provide a technology for reducing the effect of noise and improving measurement accuracy when an electrostatic capacitance is measured.

### [BRIEF DESCRIPTION OF DRAWINGS]

[FIG. 1] Fig. 1 is a schematic configuration diagram of a non-combustion-type flavor inhalation system according to an embodiment.
[FIG. 2] Fig. 2 is a perspective view of a tobacco stick according to the embodiment.
[FIG. 3] Fig. 3 is a diagram for explaining the internal structure of the tobacco stick according to the embodiment.
[FIG. 4] Fig. 4 is a diagram schematically illustrating the internal structure of a non-combustion-type flavor inhaler according to a first embodiment.
[FIG. 5] Fig. 5 is a diagram illustrating an example in which electrodes are arranged along a peripheral wall of a housing section.
[FIG. 6] Fig. 6 is a diagram illustrating an example of a capacitive sensor formed on a flexible substrate.
[FIG. 7A] Fig. 7A is a diagram illustrating an example of a shield member formed on the flexible substrate.
[FIG. 7B] Fig. 7B is a diagram illustrating an example (1) of the shield member.
[FIG. 7C] Fig. 7C is a diagram illustrating an example (2) of the shield member.
[FIG. 8] Fig. 8 is a diagram illustrating a circuit configuration of the capacitive sensor.
[FIG. 9] Fig. 9 is a diagram illustrating, as a comparative example, a circuit configuration of a capacitive sensor without an amplification unit or a shield member.
[FIG. 10] Fig. 10 is a diagram illustrating electrostatic capacitance detected by the capacitive sensor of the comparative example.
[FIG. 11] Fig. 11 is a diagram illustrating the electrostatic capacitance detected by the capacitive sensor of the present embodiment.
[FIG. 12] Fig. 12 is a diagram illustrating a configuration of a control unit.
[FIG. 13] Fig. 13 is a diagram illustrating a control method performed by the control unit.

### [DESCRIPTION OF EMBODIMENTS]

Embodiments of a non-combustion-type flavor inhalation system according to the present disclosure will now be described on the basis of the drawings. It should be noted that the dimensions, materials, shapes, relative positions, etc. of the components described in the present embodiment are examples. For example, in the present embodiment, a flavor stick (also referred to hereinafter as "tobacco stick") containing a tobacco filling material as a flavor source is described as an example of a flavor stick, but the flavor stick need not contain a tobacco filling material and may contain other flavor components.

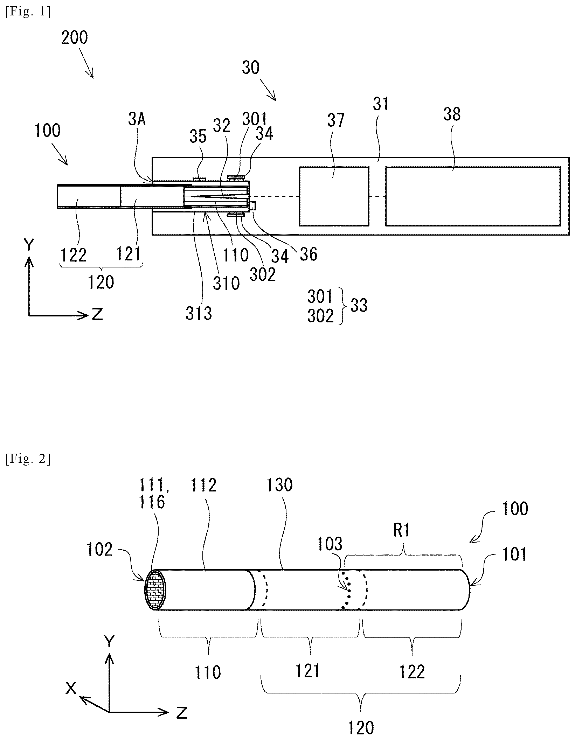

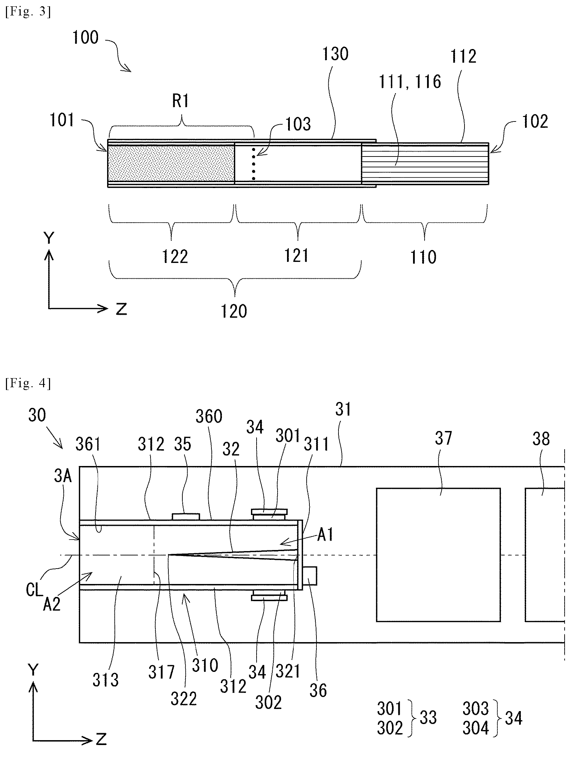

Fig. 1 is a schematic configuration diagram of a non-combustion-type flavor inhalation system 200 according to an embodiment. Fig. 2 is a perspective view of a tobacco stick 100 according to the embodiment. Fig. 3 is a diagram for explaining an internal structure of the tobacco stick 100 according to the embodiment. In figs. 1 to 3, the left-right direction of the tobacco stick 100 or a non-combustion-type flavor inhaler 30 in which the tobacco stick 100 is inserted is shown as the X direction, the up-down direction as the Y direction, and the depth direction as the Z direction. It should be noted that the same is true for the subsequent figures. These directions are merely examples given for convenience of description and do not limit the elements of the non-combustion-type flavor inhalation system 200. For example, the elements of the non-combustion-type flavor inhalation system 200 are not limited to being arranged in the directions shown in the figures.

The non-combustion-type flavor inhalation system 200 comprises the tobacco stick 100 and the non-combustion-type flavor inhaler 30 which heats a tobacco rod part (flavor rod part) 110 of the tobacco stick 100. The tobacco stick 100 is housed so as to be freely insertable into and extractable from a housing cavity 313 of a housing section 310 through an insertion opening 3A of the non-combustion-type flavor inhalation system 30.

During usage of the non-combustion-type flavor inhaler 30 by a user, the tobacco stick 100 is inserted into the housing cavity 313, a heater 32 provided in the housing section 310 is caused to generate heat in this state, and the tobacco filling material inside the tobacco stick 100 is heated, thereby generating an aerosol containing a tobacco component and providing the same for inhalation by the user. At such a time, the tobacco stick 100 is attached at a predefined position relative to the housing section 310 such that heating by the heater 32 is possible. In the present embodiment, the defined position is where the tobacco stick 100 is inserted into the housing section 310 in the Z direction and the tip of the tobacco stick 100 meets a bottom surface 319 of the housing section 310.

### [Tobacco Stick]

The tobacco stick 100 according to the present embodiment is a substantially cylindrical rod form. In the example shown in fig. 2 and fig. 3, the tobacco stick 100 includes a tobacco rod part 110, a mouthpiece part (suction part) 120, and tip paper 130 integrally connecting these. The mouthpiece part 120 is coaxially connected with the tobacco rod part 110 by being wrapped by the tip paper 130 together with the tobacco rod part 110.

The reference sign 101 is the suction end of the tobacco stick 100 (mouthpiece part 120). The reference sign 102 is the tip of the tobacco stick 100 on the side opposite to the suction end 101. The tobacco rod part 110 is arranged on the tip 102 side of the tobacco stick 100. In the example shown in fig. 2 and fig. 3, the tobacco stick 100 has a substantially constant diameter over the entire length of the longitudinal direction (also referred to hereinafter as the axial or Z direction) from the suction end 101 along the tip 102.

### <Tobacco Rod Part>

The tobacco rod part 110 is one form of a flavor rod part containing a tobacco filling material 111 as a flavor source. The configuration of the tobacco rod part 110 has no particular restriction and can be in a general form. For example, the tobacco filling 111 can be wrapped by rolling paper 112 for use as the tobacco rod part.

### [Tobacco Filling Material]

In the present embodiment, the tobacco filling material 111 is configured containing shredded tobacco. There is no particular limitation as to the material of the shredded tobacco contained in the tobacco filling material 111, and it is possible to use a well-known material such as lamina or midrib. Furthermore, ground tobacco may be formed by grinding dried tobacco leaves to an average particle size of 20 µm-200 µm, then the material which has been homogenized may be processed into a sheet (also referred to below simply as a "homogenized sheet") which is shredded. In addition, the shredded tobacco may be of what is known as the "strand-type", where the tobacco rod is filled with a material obtained by shredding, in the longitudinal direction of the tobacco rod and substantially horizontally, a homogenized sheet having a length similar to that of the tobacco rod in the longitudinal direction.

The amount of moisture contained in the tobacco filling material 111 can be 10 wt%-15 wt%, for example, and preferably 11 wt%-13 wt% with respect to the total weight of the tobacco filling material 111. A moisture content such as this suppresses formation of wrapping stains and improves rolling suitability when the tobacco rod part 110 is produced. There is no particular restriction on the size or method of preparation of the shredded tobacco contained in the tobacco filling material 111. For example, a material obtained by shredding dried tobacco leaves to a width of 0.5 mm-2.0 mm may be used. Furthermore, when ground material is used in the homogenized sheet, a sheet may be formed by grinding dried tobacco leaves to an average particle size of around 20 µm-200 µm and then homogenizing the ground tobacco, and the homogenized sheet may be shredded to a width of 0.5 mm-2.0 mm for use.

The tobacco filling material 111 may comprise an aerosol base material for generating aerosol smoke. There is no particular limitation as to the type of the aerosol base material, and various types of natural extracts and/or components thereof may be selected, according to the application. The tobacco filling material 111 may contain a flavor component such as menthol.

### [Wrapping Paper]

The wrapping paper 112 is a sheet material for wrapping the tobacco filling material 111, the composition of which is not particularly restricted and a common one can be used. For example, cellulose fiber paper can be used as the base paper used for the wrapping paper 112, or more specifically hemp or wood or mixtures thereof.

### <Mouthpiece Part>

There is no particular restriction on the configuration of the tobacco stick 100, and the tobacco stick may be in a general form. In the aspect shown in fig. 1, the mouthpiece part 120 includes two segments (sections), namely a cooling segment 121 and a filter segment 122. The cooling segment 121 is arranged so as to be sandwiched between the tobacco rod part 110 and the filter segment 122 in a state contacting the same. In another form, gaps may be formed between the tobacco rod part 110 and the cooling segment 121 and between the tobacco rod part 110 and the filter segment 122. Furthermore, the mouthpiece part 120 may be formed of a single segment.

### [Cooling Segment]

The configuration of the cooling segment 121 is not particularly restricted as long as the cooling segment has the function of cooling the tobacco mainstream smoke, and can be cylindrically processed cardboard, for example. In this case, the cylindrical inner side is a cavity, and vapor containing the aerosol generating substrate and the tobacco flavor component is in contact with the air in the cavity to be cooled. The cooling segment 121 is provided with an air flow hole 103 which is an open hole for receiving air from the outside. The number of air flow holes 103 in the cooling segment 121 is not particularly limited.

### [Filter Segment]

The configuration of the filter segment 122 is not particularly restricted as long as the filter segment has the function of a general filter, and can be cylindrically processed cellulose acetate tow, for example. In the example shown in fig. 2, the filter segment 122 is made of a single segment, but the filter segment 122 may be made of a plurality of segments.

### <Non-combustion-type Flavor Inhaler>

Fig. 4 is a diagram schematically illustrating the internal structure of a non-combustion-type flavor inhaler 30 according to the first embodiment. The non-combustion-type flavor inhaler 30 has a housing 31 which is a housing for accommodating various component parts. The inside of the housing 31 houses a heater 32, a capacitive sensor 33, a temperature sensor 35, an inhalation sensor 36, a control unit 37, a power source 38, etc.

### [Housing Section]

The housing 31 has a housing section 310 which houses the tobacco stick 100 so as to be insertable and extractable from the front end toward the rear end side. The housing section 310 comprises a cylindrical peripheral wall 312 extending in the insertion/extraction direction of the tobacco stick 100 and demarcating the outer periphery of the space in which the tobacco stick 100 is inserted, and a disc-shaped rear wall 311 that closes off the rear end of the peripheral wall 312 so as to demarcate the rear end of the space. The peripheral wall 312 and the rear wall 311 of the housing section 310 may be integrally formed with the housing 31 or may be formed separately from the housing 31 and assembled to the housing 31. In the present embodiment, the inner wall surface of the rear wall 311, i.e., the side of the space into which the tobacco stick 100 is inserted, is the bottom surface 319 of the housing section 310.

The open end of the peripheral wall 312 in the housing section 310 is open towards the outside of the housing 31 and serves as insertion opening 3A for inserting the tobacco stick 100. The internal space of the peripheral wall 312 is a cylindrically shaped housing cavity 313 through which the tip portion of the tobacco stick 100 can be inserted and extracted via the insertion opening 3A. In fig. 4, the reference sign CL shows the central axis of the housing cavity 313 in the insertion/extraction direction of the tobacco stick 100. Hereinafter, the direction along this central axis CL is also referred to as the axial direction. It should be noted that the outer diameter of the housing cavity 313, i.e., the inner diameter of the peripheral wall 312, may be equal to the outer diameter of the tobacco stick 100 or slightly larger than the outer diameter of the tobacco rod part 110. The outer diameter of the housing cavity may also be slightly smaller than the outer diameter of the tobacco rod part 110.

Within the housing cavity 313, a heater 32 is provided. The peripheral wall 312 and the rear wall 311 of the housing section 310 are formed by a material having thermal insulation performance and heat resistance performance so as to withstand the heat of the heater 32 and not diffuse the heat of the heater 32. Materials used in such a housing section 310 may include, for example, alumina-silica ceramics, and resins such as heat-resistant PEEK (polyether ether ketone), PPS (polyphenylene sulfide), and PTFE (polytetrafluoroethylene).

### [Heater]

The heater 32 receives a supply of electrical power from the control unit 37 and generates heat to heat the tobacco stick 100 housed in the housing section 310. That is, the heater 32 is one form of a heating unit which heats the tobacco stick 100.

The heater 32 is a generally rod-shaped member extending along the axial direction of the housing cavity 313 and is conically shaped in the present embodiment. The heater 32 is provided projecting axially from the center of the rear wall 311 in the housing section 310 to the front. The reference sign 321 is the proximal end of the heater 32 and the reference sign 322 is the distal end of the heater 32.

The heater 32 extends from the rear wall 311 toward the insertion opening 3A and is gradually tapered from the proximal end 321 towards the distal end 322. Note that the shape of the heater 32 is not limited to this and may be rod-shaped or flat-shaped (blade-shaped) of the same diameter from the base end 321 to the distal end 322.

The types of heaters 32 are not particularly limited, and, for example, a heater in which heating wiring (e.g., wiring with high electrical resistance such as nichrome, chromium iron, and iron nickel) is spread, or a ceramic heater, a sheathed heater, etc., may be used. Note that a sheathed heater is a heater which covers the heating wiring with a metal pipe together with a filler.

When the tobacco stick 100 is inserted into the housing cavity 313, the heater 32 is fitted into the tobacco rod part 110 from the tip 102 of the tobacco stick 100. Fig. 1 shows the tobacco stick 100 inserted into the housing cavity 313. In this state, the heater 32 receives a supply of electrical power from the control unit 37 to heat the tobacco rod part 110 at a predetermined temperature as described later. It should be noted that the heater 32 only needs to be able to heat the tobacco rod part 110 to generate an aerosol, and the heating method thereof is not particularly limited. For example, in fig. 4, a method of heating from the inside of the tobacco rod part 110 is shown, but the method may be a method of heating from the outer periphery of the tobacco rod part 110 or a heating method using an inductive heater.

### [Sensor]

The capacitive sensor 33 is a sensor that detects the electrostatic capacitance of the tobacco stick 100 when the tobacco stick 100 is housed in the housing section 310. The capacitive sensor 33 has a first electrode (first electrode) 301 and a second electrode (second electrode) 302 and detects the electrostatic capacitance between the first electrode 301 and the second electrode 302. The first electrode 301 and the second electrode 302 are arranged at opposite positions across a heating region A1 in a direction orthogonal to the axial direction of the housing cavity 313 (radial direction). In other words, the first electrode 301 and the second electrode 302 are arranged such that when the tobacco stick 100 is housed in the housing cavity 313, at least a part of the tobacco rod part 110 is inserted between the first electrode 301 and the second electrode 302. The electrostatic capacitance generated between the electrodes 301, 302 via the tobacco rod part 110 varies depending on, for example, the presence or absence of insertion of the tobacco rod part 110, the insertion position of the tobacco rod part 110, the amount of moisture of the tobacco filling material in the tobacco rod part 110, the aerosol substrate, etc. As such, the capacitive sensor 33 can detect information indicative of the state of the tobacco rod part 110 by detecting this capacitance.

Each electrode 301, 302 is provided along at least the housing cavity depth direction (Z-axis direction) of an outer peripheral surface 360 at the peripheral wall 312 of the housing section 310. The outer peripheral surface 360 of the peripheral wall 312 is the surface opposite to the surface (inner peripheral surface) 361 on the side of the housing cavity 313 sandwiching the peripheral wall 312 in the radial direction of the peripheral wall 312, and is the surface positioned on the side of the internal space housing the capacitive sensor 33, the control unit 37, etc. in the housing 31.

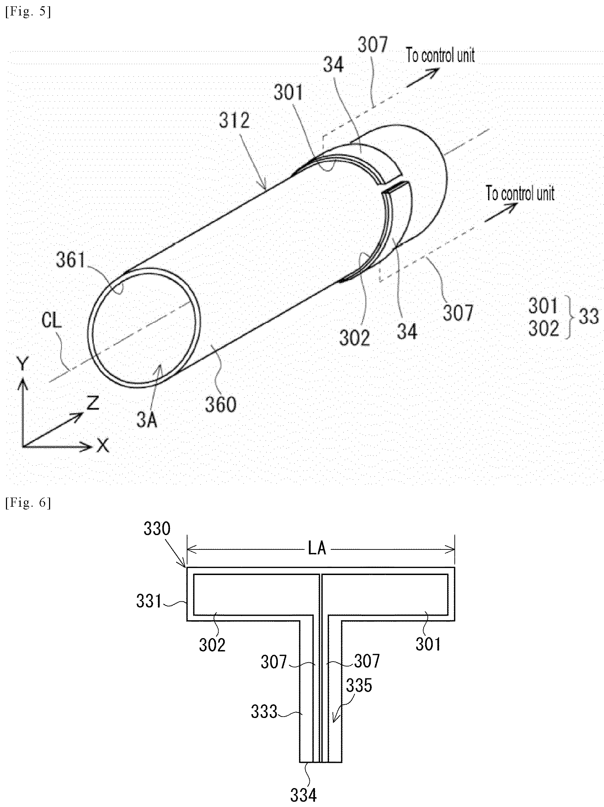

Fig. 5 is a diagram illustrating an example in which curved electrodes 301, 302 are arranged along the peripheral wall 312 of the housing section 310. In the example of fig. 5, each electrode 301, 302 is provided curved along the circumferential direction of the outer peripheral surface 360 at the peripheral wall 312, and the shield member 34 is arranged to cover the outside thereof. The first electrode 301 and the second electrode 302 are electrically connected to the control unit 37 via wiring 307, and the electrostatic capacitance detection results are acquired by the control unit 37.

The shield member 34 is arranged to cover at least a portion of the electrodes 301, 302, such as a portion other than the surface opposing the housing section 310. In other words, the shield member 34 is arranged outside of the electrodes 301, 302 in the radial direction of the housing section 310 and covers the outer periphery of the electrodes 301, 302.

The shape of each electrode 301, 302 and the shield member 34 is not particularly limited and may be flat-shaped. That is, the flat-shaped first electrode 301 and the flat-shaped second electrode 302 may oppose each other in the radial direction with the peripheral wall 312 therebetween, and may be held in a state in contact with the outer peripheral surface 360 so as to be parallel to each other, and the shield member 34 may be arranged on the outside thereof. However, as shown in fig. 5, using curved electrodes 301, 302 facilitates radial miniaturization compared to arranging flat-shaped electrodes 301, 302. Furthermore, by using curved electrodes 301, 302, each electrode 301, 302 follows the housing cavity 313 in the circumferential direction and is disposed at a position close to the tobacco stick 100 across the entire circumferential direction, thus suppressing the effect of noise and making it possible to detect the electrostatic capacitance with high accuracy.

Fig. 6 is a diagram illustrating an example of the capacitive sensor 33 formed on a flexible substrate. The flexible substrate 330 comprises a first strip-shaped portion 331 formed longitudinally in one direction and a second strip-shaped portion 333 formed longitudinally from a longitudinal-direction center portion of the first strip-shaped portion 331 in a direction orthogonal to the first strip-shaped portion 331.

The first strip-shaped portion 331 is provided with the first electrode 301 of the capacitive sensor 33 in one of the longitudinal directions and the second electrode 302 in the other, with predetermined spacing in the longitudinal-direction center. The second strip-shaped portion 333 is formed to an end 334 where the wiring 307 connected with each electrode 301, 302 is connected with the control unit 37 along the longitudinal direction of the second strip-shaped portion 333.

The length LA in the longitudinal direction of the first strip-shaped portion 331 is formed substantially the same or slightly shorter than the circumferential-direction length at the outer peripheral surface 360 of the peripheral wall 312. By arranging the first strip-shaped portion 331 of this flexible substrate 330 along the outer peripheral surface 360 of the housing section 310, the electrodes 301, 302 can be provided curved along the circumferential wall as shown in fig. 5.

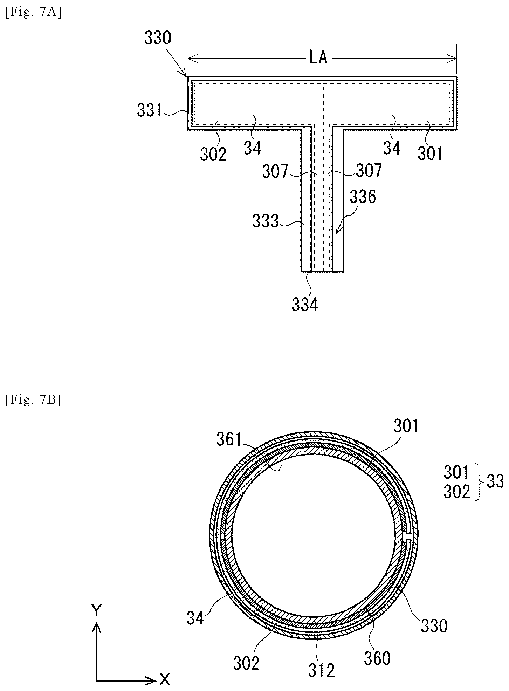

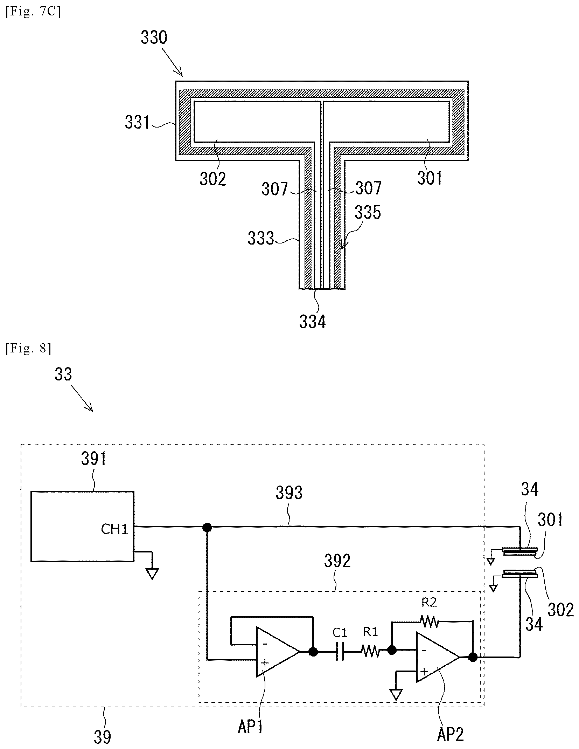

Furthermore, fig. 7A is a diagram illustrating an example of the shield member 34 formed on the flexible substrate. The shield member 34 is formed on a surface 336 of the flexible substrate 330 opposite to a surface 335 on which the first electrode 301 and the second electrode 302 are provided. As shown in fig. 5, when the flexible substrate 330 is provided along the peripheral wall 312, the first electrode 301 and the second electrode 302 are positioned on the inside and the shield member 34 is arranged to be positioned on the outside. That is, the shield member 34 is arranged to cover the outside of the first electrode 301 and the second electrode 302. In the example of fig. 7A, the flexible substrate 330 was configured to cover the outside of the electrodes 301, 302 with another layer (shield member 34) provided on the opposite side of the electrodes 301, 302, but the configuration is not limited to this, and the shield member 34 may be in other configurations as long as the shield member can reduce noise to the electrodes 301, 302. For example, as shown in fig. 7B, another member (shield member 34) may be arranged outside the flexible substrate 330 to cover the outer periphery of the first electrode 301 and the second electrode 302. As shown in fig. 7C,
the shield member 34 may be arranged as a GND layer to surround the first electrode 301 and the second electrode 302, in substantially the same plane as the first electrode 301 and the second electrode 302. These configurations may also be used in combination.

It should be noted that, in the example of fig. 5, each electrode 301, 302 and the shield member 34 were provided on the outer peripheral surface 360 of the peripheral wall 312, but the invention is not limited to this, and each electrode 301, 302 and the shield member 34 may be provided on the inner peripheral surface 361 side of the peripheral wall 312. Furthermore, each electrode 301, 302 and shield member 34 may be buried in the peripheral wall 312.

The shield member 34 is, for example, formed of a conductor such as copper, aluminium, iron, or alloys thereof, and connected to the ground of the control unit. The shield member 34 electrically shields the electrodes 301, 302 by covering the electrodes, and reduces the effect of noise on the electrodes 301, 302.

The thickness of the shield member 34 is not particularly limited, and may be 1 µm to 1000 µm, for example. The shield member 34 of the present embodiment has a thickness of 30 µm. It should be noted that the shield member 34 of the present embodiment is provided integrally with the electrodes 301, 302, but may be provided separately from the electrodes 301, 302. In this case, it is desirable that the shield member 34 is arranged to be between a user in contact with the non-combustion-type flavor inhaler 30 and the electrodes 301, 302. For example, a portion of the housing at a position covering the electrodes 301, 302 may be formed of metal and configured to function as the shield member 34.

Fig. 8 is a diagram illustrating a circuit configuration of the capacitive sensor 33. The capacitive sensor 33 comprises a measurement unit 39 which measures the electrostatic capacitance between the electrodes 301, 302. An IC 391 of the measurement unit 39 detects the electrostatic capacitance between the electrodes by applying a measurement signal to the electrodes 301, 302 and converting the electrostatic capacitance between the first electrode 301 and the second electrode 302 to a voltage. The electrostatic capacitance between these electrodes is detected at a defined value when the tobacco stick 100 is not inserted, whereas the electrostatic capacitance changes when the tobacco stick 100 is inserted, and this change is detected as the electrostatic capacitance of the tobacco stick 100.

The measurement unit 39 of the present embodiment is provided with an amplification unit 392 to improve the detection sensitivity. The measurement signal from the IC 391 is applied to one electrode 301 via wiring 393 and is amplified at the amplification unit 392 and applied to the other electrode 302. The amplification unit 392 of the present embodiment comprises an amplifier AP1 and an amplifier AP2, as shown in fig. 8, the amplifier AP1 achieves a high input impedance and a low output impedance, and the amplifier AP2 amplifies the output signal of the amplifier AP1 by a predetermined factor, inverts the phase, and applies the same to the electrode 302. This increases the potential difference across the electrodes 301, 302 when the measurement signal is applied, and the electrostatic capacitance across the electrodes 301, 302 is simulated to increase.

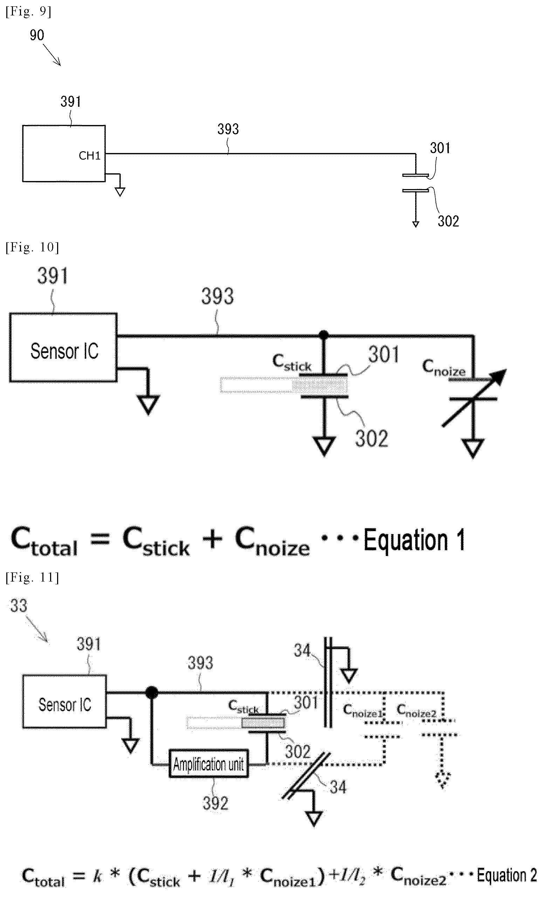

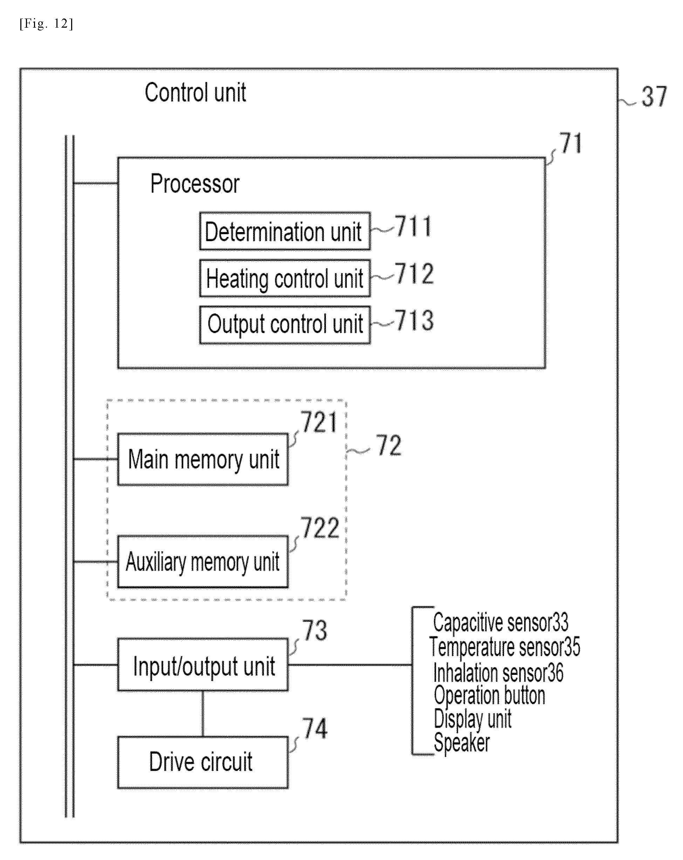

Fig. 9 is a diagram illustrating, as a comparative example, a circuit configuration of a capacitive sensor 90 without the amplification unit 392 or the shield member 34. In the capacitive sensor 90 of fig. 9, a measurement signal is applied from the IC 391 to the electrode 301 to determine the electrostatic capacitance between the electrodes 301, 302. In this case, the detected capacitance Cₜₒₜₐₗ is the result of the noise C_{noize} being added to the electrostatic capacitance C_{stick} of the tobacco stick 100, as shown in equation 1 of fig. 10. Note that the analytical formula of fig. 10 and fig. 11 is a simple representation and may be used as a method for finding the electrostatic capacitance Cₜₒₜₐₗ including the other components. Here, C_{noize} is, for example, a variable component of electrostatic capacitance due to a user touching the non-combustion-type flavor inhaler 30 or the tobacco stick 100 inserted into the non-combustion-type flavor inhaler 30. The non-combustion-type flavor inhaler 30 is used in the hand by a user, and the detected electrostatic capacitance Cₜₒₜₐₗ varies significantly depending on how the inhaler is held, where the inhaler is held, whether the user is holding the tobacco stick 100 in their mouth or not, etc. In this case, the variable component of the electrostatic capacitance Cₜₒₜₐₗ, or namely the noise C_{noize}, is 1 pF to 200 pF, for example. Meanwhile, since the electrostatic capacitance C_{stick} of the tobacco stick 100 is in the order of pF, it is desirable to effectively suppress the noise component in order to accurately detect the electrostatic capacitance C_{stick}.

Fig. 11 is a diagram illustrating the electrostatic capacitance detected by the capacitive sensor 33 of the present embodiment. In equation 2 of fig. 11, k is the amplification rate by the amplification unit 392, and 1/l₁, 1/l₂ is the attenuation rate of the noise by the shield member 34. If the electrostatic capacitance is amplified without the shield member 34 inserted, the electrostatic capacitance will be amplified to noise C_{noize} caused by the human body, etc., and consequently the S/N ratio will not be improved. Therefore, in order to relatively reduce the effect of noise C_{noize}, the shielding of noise components is performed with the shield member 34. The component (C_{noize1}) added in parallel with the electrostatic capacitance C_{stick} among the noise C_{noize} is amplified by the amplification unit 392, but the electrostatic capacitance component (C_{noize2}) to GND caused by the human body is not amplified by the amplification unit 392. The noise component is therefore substantially reduced and the S/N ratio can be improved. It should be noted that it is desirable that the amplification unit 392 is disposed as close as possible to the second electrode 302 in order to reduce the parasitic capacitive component. For example, the distance from the second electrode 302 is defined in accordance with the required accuracy, and the amplification unit 392 is arranged to be within this predetermined distance from the second electrode 302.

The non-combustion-type flavor inhaler 30 may also comprise a sensor other than the capacitive sensor 33. As shown in fig. 1, a temperature sensor 35 is provided near the outer periphery of the housing section 310. The temperature sensor 35 is connected to the control unit 37 to detect the temperature of the heating region A1 and input the detection result to the control unit 37. Furthermore, the housing section 310 is provided with an inhalation sensor 36. The inhalation sensor 36 is a sensor for detecting a status of a puff, such as whether a puff has been taken or not, and is a pressure sensor for detecting the pressure in the housing cavity 313, for example. The inhalation sensor 36 is connected to the control unit 37 and inputs the detection result to the control unit 37. It should be noted that the temperature sensor 35 is not an essential configuration, and if the detection result of the temperature sensor is not used for control, such as the control unit 37 controlling the temperature by a current value supplied to the heater 32, the temperature sensor 35 may be omitted. Similarly, if information about inhalation is not used for control, the inhalation sensor 36 may be omitted.

### [Control Unit]

Fig. 12 is a diagram illustrating a configuration of the control unit 37. The control unit 37 controls the operational state of the non-combustion-type flavor inhaler 30, such as controlling heating by the heater 32. The control unit 37 is a computer comprising a processor 71, such as a central processing unit (CPU), a digital signal processor (DSP), or a field-programmable gate array (FPGA), a memory 72, such as a random access memory (RAM) or a read only memory (ROM), and an input/output unit 73, for example. The control unit 37 of the present embodiment comprises a drive circuit 74 for the heater 32.

The memory 72 may comprise each of a unit functioning as a main memory unit 721 and a unit functioning as an auxiliary memory unit 722. Note that the memory 72 may be formed integrally (one chip) with the processor 71. Examples of the memory 72 include a volatile memory such as RAM, non-volatile memory such as ROM, erasable programmable ROM (EPROM), or a memory medium such as SSD (Solid State Drive) or removable media, for example.

The memory 72 can store an operating system (OS), various programs (firmware), various data tables, various databases, setting data, user data, etc. for performing the operation of the non-combustion-type flavor inhaler 30.

The input/output unit 73 is a means for inputting operation information such as power ON/OFF by the user (smoker) to the processor 71 or outputting information to be presented to the user. The input/output unit 73 operates the capacitive sensor 33, the temperature sensor 35, and the inhalation sensor 36 at a predetermined timing, for example, and is an interface for obtaining the detected values from each sensor 33, 35, 36. The input/output unit 73 of the present embodiment comprises an operation button, an input means such as a touch panel, a display unit, and an output means such as a vibrator or a speaker. The input/output unit 73 may also comprise a communication unit for communicating with an external device via a communication line. For example, the communication unit connects with other computers via a communication cable and receives programs and data for controlling the non-combustion-type flavor inhaler 30 and stores the same in the memory 72, thereby making it possible to update the firmware, heating profile, etc. The display unit is a means for displaying information, and may be an indicator such as an LED, a liquid crystal display device, and an organic EL display device, for example.

The drive circuit 74 supplies electrical power from the power source 38 to the heater 32 in accordance with a command from the processor 71, and operates the heater 32. The drive circuit 74 is a converter that regulates the amount of current passed to the heater 32, for example.

The control unit 37 is configured to read and execute a program stored in the memory 72 by the processor 71 into a work area of the main memory unit, and functions as a predetermined functional unit, such as a determination unit 711, a heating control unit 712, and an output control unit 713, for example. Note that these functional units are not limited to those realized on the basis of programs (software), and some or all of the functional units may be formed of a processor, integrated circuits, and hardware circuits such as logic circuits.

The determination unit 711 determines, on the basis of the detection results of each sensor 33, 35, 36 and input information from the input means, information such as an operation by the user, a state of the tobacco stick 100, and the heating status by the heater 32. For example, the determination unit 711 determines, from the detected value by the capacitive sensor 33, at least one among whether the tobacco stick 100 has been inserted in a defined position, the insertion position of the tobacco stick 100, whether the tobacco stick 100 has been heated, the amount of moisture of the tobacco stick 100, the amount of aerosol source of the tobacco stick 100, the amount of flavor source of the tobacco stick 100, and the type of flavor stick.

The heating control unit 712 controls the drive circuit 74 on the basis of the determination results of the determination unit 711 to thereby control the electrical power supplied from the power source 38 via the drive circuit 74 to the heater 32.

The output control unit 713 outputs notifications, warnings, etc. to the user on the basis of the determination results of the determination unit 711. For example, the output control unit 713 outputs a warning when the insertion position of the tobacco stick 100 is not appropriate, and as an output to the user, the output control unit 713 performs display on the display unit, sound output by the speaker, vibration by the vibrator, for example, to output the warning, etc.

### [Control Method]

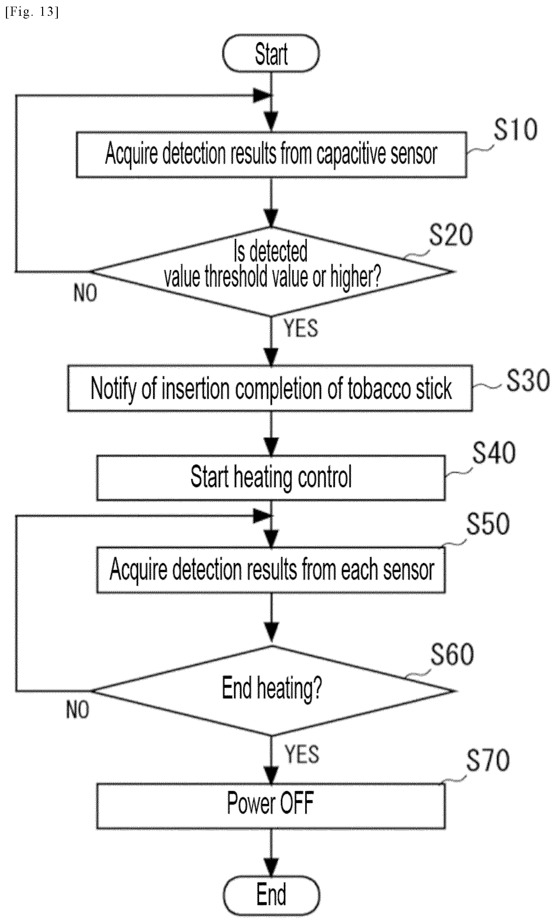

Fig. 13 is a diagram illustrating a control method performed by the control unit 37. The control unit 37 starts the process of fig. 9 when the non-combustion-type flavor inhaler 30 is powered ON.

In step S10, the control unit 37 acquires the detected value from the capacitive sensor 33. The control unit 37 stores the acquired detected value in the memory 72.

In step S20, the control unit 37 determines whether the detected value detected in step S10 is greater than or equal to a threshold value. This threshold value is the lower limit of the detected value obtained when the tobacco stick 100 is inserted in the defined position. That is, the control unit 37 can determine that the tobacco stick 100 has reached the defined position if the detected value detected in step S10 is greater than or equal to the threshold value. Note that if a negative determination is made in step S20, the control unit 37 returns to step S10. At such a time, a message may be output indicating that the insertion of the tobacco stick 100 has not been completed, such as "Please insert the tobacco stick".

If a positive determination is made in step S20, the control unit 37 moves to step S30 and notifies the user that the insertion of the tobacco stick 100 has been completed, such as by illuminating an indicator.

In step S40, the control unit 37 performs heating control on the basis of a predetermined heating profile. The control unit 37 controls the electrical power supplied to the heater 32 such that the temperature of the region (heating region) heated by the heater 32 is a heating temperature defined in the heating profile, for example.

In step S50, the control unit 37 obtains detected values from the capacitive sensor 33, the temperature sensor 35, the inhalation sensor 36, etc.

In step S60, the control unit 37 determines whether or not to end heating on the basis of the detection results obtained in step S50. That is, on the basis of the detection results obtained in step S50, the control unit 37 is configured to make a positive determination when the predetermined end condition is met, such as when the amount of moisture of the tobacco rod part has dropped below a predetermined value, or when the puff count has reached a predetermined value.

If a positive determination is made in step S60, the control unit 37 moves to step S70 and turns OFF the power supply of the non-combustion-type flavor inhaler 30 to end the process of fig. 13

### [Effects of Embodiment]

The non-combustion-type flavor inhaler 30 of the present embodiment comprises the shield member 34 covering at least a portion of the plurality of electrodes 301, 302, thereby reducing the effect of noise and improving the measurement accuracy of the electrostatic capacitance.

Furthermore, the non-combustion-type flavor inhaler 30 of the present embodiment comprises the amplification unit 392, which increases the detected electrostatic capacitance relative to the noise, thereby making it possible to reduce the effect of the noise and improve the measurement accuracy of the electrostatic capacitance.

### (Aspect 1)

To achieve the above objectives, a non-combustion-type flavor inhaler as set forth in one aspect of the present disclosure comprises:
a housing section in which a flavor stick having a flavor rod part and a suction part is housed in an insertable and extractable manner,
a capacitive sensor which is provided with a plurality of electrodes arranged along the housing section and detects an electrostatic capacitance between the plurality of electrodes which varies depending on the state of the flavor stick that is inserted into and extracted from the housing section; and
a shield member which covers at least a portion of the plurality of electrodes to electrically shield the portion of the electrodes.

### (Aspect 2)

In the above aspect 1, the capacitive sensor may comprise a measurement unit for supplying a signal to the plurality of electrodes and for measuring an electrostatic capacitance between the plurality of electrodes on the basis of the signal via the electrodes, and an amplification unit for amplifying the signal.

### (Aspect 3)

In the above aspect 2, the plurality of electrodes may be made up of a first electrode and a second electrode, and the amplification unit may amplify the signal supplied to the second electrode to increase a potential difference across the first electrode and the second electrode when the signal is supplied.

### (Aspect 4)

In any one of the above aspects 1 to 3, the shield member may be a conductor.

### (Aspect 5)

In any one of the above aspects 1 to 4, the thickness of the shield member may be 1 µm to 1000 µm.

### (Aspect 6)

In any one of the above aspects 1 to 5, the electrodes may be formed on one surface of a flexible substrate and the shield member may be formed on a surface of the flexible substrate opposite to the surface on which the electrodes are formed.

### (Aspect 7)

To achieve the above objectives, a capacitive sensor as set forth in one aspect of the present disclosure is
a capacitive sensor provided to a non-combustion-type flavor inhaler comprising a housing section that houses a flavor stick in an insertable and extractable manner, the capacitive sensor comprising:
a plurality of electrodes arranged along the housing section;
a measurement unit for measuring an electrostatic capacitance between the plurality of electrodes which varies depending on the state of the flavor stick that is inserted into and extracted from the housing section; and
a shield member which covers at least a portion of the plurality of electrodes other than a surface opposing the housing section to electrically shield the portion of the electrodes.

### (Aspect 8)

In the above aspect 7, the capacitive sensor may further comprise an amplification unit for amplifying a signal supplied from the measurement unit to the plurality of electrodes.

### [REFERENCE SIGNS LIST]

100: Tobacco stick
101: Suction end
102: Tip
103: Air flow hole
110: Tobacco rod part
111: Filling material
112: Wrapping paper
120: Mouthpiece part
121: Cooling segment
122: Filter segment
130: Tip paper
200: Non-combustion-type flavor inhalation system
30: Non-combustion-type flavor inhaler
301: First electrode
302: Second electrode
307, 308: Wiring
31: Housing
310: Housing section
311: Rear wall
312: Peripheral wall
313: Housing cavity
32: Heater
321: Proximal end
322: Distal end
325: Gap portion
325: Empty space
325: Coil
326: Heating element
33: Capacitive sensor
330: Flexible substrate
35: Temperature sensor
36: Inhalation sensor
37: Control unit
38: Power source (battery unit)
39: Measurement unit
391: IC
392: Amplification unit
3A: Insertion opening
71: Processor
711: Determination unit
712: Heating control unit
713: Output control unit
72: Memory
73: Input/output unit
74: Drive circuit

## Claims

1. A non-combustion-type flavor inhaler comprising:
a housing section in which a flavor stick having a flavor rod part and a suction part is housed in an insertable and extractable manner;
a capacitive sensor which is provided with a plurality of electrodes arranged along the housing section and detects an electrostatic capacitance between the plurality of electrodes which varies depending on the state of the flavor stick that is inserted into and extracted from the housing section; and
a shield member which covers at least a portion of the plurality of electrodes to electrically shield the portion of the electrodes.

2. The non-combustion-type flavor inhaler as claimed in claim 1, wherein the capacitive sensor comprises a measurement unit for supplying a signal to the plurality of electrodes and for measuring an electrostatic capacitance between the plurality of electrodes on the basis of the signal via the electrodes, and an amplification unit for amplifying the signal.

3. The non-combustion-type flavor inhaler as claimed in claim 2, wherein the plurality of electrodes is made up of a first electrode and a second electrode, and
the amplification unit amplifies the signal supplied to the second electrode to increase a potential difference across the first electrode and the second electrode when the signal is supplied.

4. The non-combustion-type flavor inhaler as claimed in any one of claims 1 to 3, wherein the shield member is a conductor.

5. The non-combustion-type flavor inhaler as claimed in any one of claims 1 to 4, wherein the thickness of the shield member is 1 µm to 1000 µm.

6. The non-combustion-type flavor inhaler as claimed in any one of claims 1 to 5, wherein the electrodes are formed on one surface of a flexible substrate and the shield member is formed on a surface of the flexible substrate opposite to the surface on which the electrodes are formed.

7. A capacitive sensor provided to a non-combustion-type flavor inhaler comprising a housing section that houses a flavor stick in an insertable and extractable manner, the capacitive sensor comprising:
a plurality of electrodes arranged along the housing section;
a measurement unit for measuring an electrostatic capacitance between the plurality of electrodes which varies depending on the state of the flavor stick that is inserted into and extracted from the housing section; and
a shield member which covers at least a portion of the plurality of electrodes other than a surface opposing the housing section to electrically shield the portion of the electrodes.

8. The capacitive sensor as claimed in claim 7, further comprising an amplification unit for amplifying a signal supplied from the measurement unit to the plurality of electrodes.
